# EUROPEAN PATENT APPLICATION

(11) **EP 4 401 124 A1**
(43) Date of publication of application: **17.07.2024**
(21) Application number: 23202558.5
(22) Date of filing: 10.10.2023
(51) Int. Cl.: H01L 23/00, H01L 23/58, H01L 29/778, H01L 29/10

(54) **SEAL RING STRUCTURES**

(30) Priority: 10.01.2023 US 202318095156
(71) Applicant: GlobalFoundries U.S. Inc., Malta, NY 12020 (US)
(72) Inventor: LEVY, Mark D., Essex Junction, VT, 05452 (US); CUCCI, Brett T., Essex Junction, VT, 05452 (US); PORTER, Spencer H., Essex Junction, VT, 05452 (US); SHARMA, Santosh, Austin, TX, 78735 (US)
(74) Representative: Lambacher, Michael

(57) **Abstract**

The present disclosure relates to semiconductor structures and, more particularly, to seal ring structures and methods of manufacture. The structure includes: a semiconductor substrate; a channel layer above the semiconductor substrate; a trench within the channel layer, extending to the semiconductor substrate; and a moisture barrier layer lining sidewalls and a bottom surface of the trench.

## Description

### BACKGROUND

This invention was made with government support under contract HQ0727790700 awarded by Defense Microelectronics Agency (DMEA). The government has certain rights in the invention.

The present disclosure relates to semiconductor structures and, more particularly, to seal ring structures and methods of manufacture.

MOSFET devices are used in power switches in power applications, amongst other applications. MOSFET devices continue to improve in key parameters, e.g., on-resistance, voltage ratings, switching speed, etc. However, performance of MOSFET devices may be coming close to their physical limitations.

To continue with improvements, GaN devices have become attractive in many applications. GaN devices are high electron mobility transistor (HEMT) devices. Accordingly, GaN devices may have a higher electric-field strength than conventional MOSFETS, providing further performance improvements in, for example, on-resistance and breakdown voltage while offering fast switching speed amongst other important parameters. GaN devices, though, are very susceptible to moisture penetration, which may affect device performance and integrity.

### SUMMARY

In an aspect of the disclosure, a structure comprises: a semiconductor substrate; a channel layer above the semiconductor substrate; a trench within the channel layer, extending to the semiconductor substrate; and a moisture barrier layer lining sidewalls and a bottom surface of the trench.

Additional features of the structure are set forth in dependent claims 2 to 9.

In an aspect of the disclosure, a structure comprises: a first semiconductor substrate; a second semiconductor substrate having a bandgap different than the semiconductor substrate: a trench in the second semiconductor substrate at an edge of an active region and which extends to the first semiconductor substrate; a moisture barrier layer lining sidewalls and a bottom surface of the trench; and metal material within the trench and extending outside of the trench, at least above the moisture barrier layer.

Additional features of the structure are set forth in dependent claims 11 to 14.

In an aspect of the disclosure, a method comprises: forming a channel layer above a semiconductor substrate; forming a trench within the channel layer, extending to the semiconductor substrate; and forming a moisture barrier layer lining sidewalls and a bottom surface of the trench.

### BRIEF DESCRIPTION OF THE DRAWINGS

The present disclosure is described in the detailed description which follows, in reference to the noted plurality of drawings by way of non-limiting examples of exemplary embodiments of the present disclosure.
FIG. 1 shows a seal ring structure, amongst other features, in accordance with aspects of the present disclosure.
FIGS. 2-6 show additional seal ring structures, amongst other features, in accordance with aspects of the present disclosure.
FIGS. 7A-7G show fabrication processes for manufacturing the structure of FIG. 1 in accordance with aspects of the present disclosure.

### DETAILED DESCRIPTION

The present disclosure relates to semiconductor structures and, more particularly, to seal ring structures and methods of manufacture. More specifically, the present disclosure relates to seal ring structures for GaN devices. Advantageously, the seal ring structures prevent moisture ingress into a GaN layer of a high electron mobility transistor (HEMT).

In more specific embodiments, a III-V device comprises a substrate, a channel layer (e.g., GaN) above the substrate and a moisture barrier layer within a trench in the channel layer. The trench may extend entirely through the channel layer at an edge thereof. The moisture barrier layer will line the sidewalls and the bottom of the trench, thereby preventing ingress of moisture into the active region.

The seal ring structures of the present disclosure can be manufactured in a number of ways using a number of different tools. In general, though, the methodologies and tools are used to form structures with dimensions in the micrometer and nanometer scale. The methodologies, i.e., technologies, employed to manufacture the seal ring structures of the present disclosure have been adopted from integrated circuit (IC) technology. For example, the structures are built on wafers and are realized in films of material patterned by photolithographic processes on the top of a wafer. In particular, the fabrication of the seal ring structures uses three basic building blocks: (i) deposition of thin films of material on a substrate, (ii) applying a patterned mask on top of the films by photolithographic imaging, and (iii) etching the films selectively to the mask. In addition, precleaning processes may be used to clean etched surfaces of any contaminants, as is known in the art. Moreover, when necessary, rapid thermal anneal processes may be used to drive-in dopants or material layers as is known in the art.

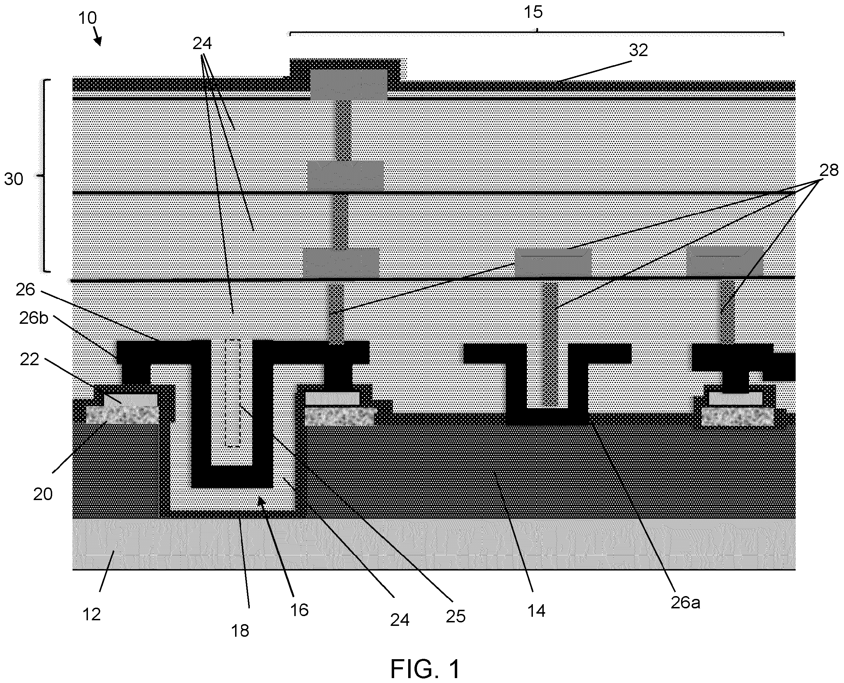

FIG. 1 shows a seal ring structure, amongst other features, in accordance with aspects of the present disclosure. More specifically, the structure 10 of FIG. 1 includes a GaN stack 14 provided on a semiconductor substrate 12. In embodiments, the semiconductor substrate 12 may be any appropriate substrate material used in a III-V device including, but not limited to, Si, SiC or Sapphire, as examples.

The GaN stack 14 may comprise a channel layer for a HEMT or metal insulator silicon HEMT (MISHEMT), and may include different layers including, but not limited to, a buffer layer on the semiconductor substrate 12, e.g., AlN, a GaN layer on top of the buffer layer and a top layer of AlGaN. It should be understood by those of ordinary skill in the art that other materials may be used in the stack of materials, and that the above example is merely an illustrative, non-limiting example. For example, the GaN layer may include different percentage concentrations of Ga as this layer transitions from an upper surface to a lower surface. Also, in preferred embodiments, the semiconductor substrate 12 and the GaN stack 14 may include different bandgaps.

Still referring to FIG. 1, a trench 16 may be formed in the GaN stack 14, on an outer edge of an active region 15. In embodiments, the trench 16 may extend to the semiconductor substrate 12. The trench 16 may be lined with a moisture barrier layer 18 on all sides and a bottom surface. The moisture barrier layer 18 may also be formed, e.g., deposited, on an upper surface of the GaN stack 14. As should be understood by those of ordinary skill in the art, the moisture barrier layer 18 will prevent moisture ingress into the active region 15 of the GaN stack 14 from both an upper surface and an outer edge.

In embodiments, the moisture barrier layer 18 may be, for example, a nitride material. In more specific embodiments, the moisture barrier layer 18 may be, for example, Al₂O₃ and nitride material. In further embodiments, the moisture barrier layer 18 may be other materials such as SiN or a non-conductive material.

FIG. 1 further shows a patterned p-doped GaN material 20 and conductive material 22 under the moisture barrier layer 18. In embodiments, the conductive material 22 may be TiN or other conductive materials known in the art. In alternative embodiments, the p-doped GaN material 20 and conductive material 22 may be replaced with a thin dielectric material for a MISHEMT.

In embodiments, the p-doped GaN material 20 and the conductive material 22 may be provided on both sides of the trench 16 (e.g., outside of the trench 16) and at a remote location from the trench 16 in the active region 15. The p-doped GaN material 20 may be in direct contact with an upper surface of the GaN stack 14 and the conductive material 22 may be in direct contact with the p-doped GaN material 20. The conductive material 22 and p-doped GaN material 20 may be patterned over the GaN stack 14 to form respective gate structures in combination with a gate material 26.

An interlevel dielectric material 24 and gate material 26 may be provided within the trench 16, above the moisture barrier layer 18. The gate material 26 may also be provided over and in contact with the conductive material 22 on the side of the trench 16 and at a location remote from the trench 16 in the active region 15 (e.g., forming another gate structure). In this way, the combination of the gate material 26, p-doped GaN material 20, conductive material 22 may form gate structures, with a channel region in the GaN stack 14.

A metal material 26a may be formed in contact with the GaN stack 14 in the active region 15. That is, the metal material 26a may be formed directly on, e.g., contacting, the GaN stack 14, extending through an opening in the moisture barrier layer 18. The metal material 26a may a source/drain contact, as an example. Additional gate material extending to the conductive material 22 on an outer edge of the trench 16 may be used as a guard ring structure 26b, e.g., a crack stop feature. As should be understood by those of ordinary skill in the art, in this manner, the moisture barrier layer 18 may be co-integrated with the guard ring structure.

The materials 22, 26, 26a, may be the same metal materials. For example, the materials 22, 26, 26a may aluminum, an aluminum base material, WN, TiN, or TaN, or combinations thereof, etc.

Additional interlevel dielectric material 24 may be provide above the materials 22, 26, 26a. An optional air gap structure 25 may be formed in the trench 16, above the gate material 26 and within the interlevel dielectric material 24. The air gap structure 25 may be formed due to a pinch-off process during the deposition of the additional interlevel dielectric material 24 above the gate material 26. In embodiments, the interlevel dielectric material 24 may be an oxide and/or nitride material.

FIG. 1 further shows contacts 28 extending to the materials 26, 26a (e.g., gate metal and source/drain contacts). As an example, the contacts 28 may be tungsten; although other materials are also contemplated herein such as copper or cobalt, as examples. The structure 10 further includes back end of the line (BEOL) structures 30, with an upper passivation layer 32 provided over the BEOL structures 30. For example, the BEOL structures 30 may include interconnects and wiring structures at different wiring levels of the structure 10 as is known in the art such that no further explanation is required for a complete understanding of the present disclosure. The passivation layer 32 may be a nitride material or other moisture barrier layer.

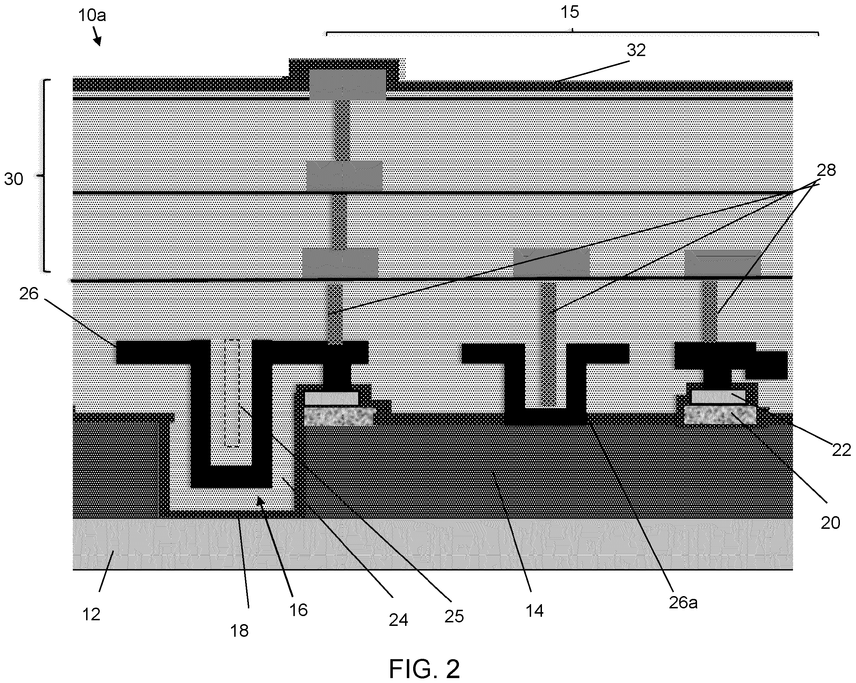

In the structure 10a of FIG. 2, the p-doped GaN material 20 and conductive material 22, e.g., TiN, are not provided at the outer edge of the trench 16. Instead, the p-doped GaN material 20 and conductive material 22, e.g., TiN, may be provided under the moisture barrier layer 18 at an inner edge of the trench 16 and at a remote location from the trench 16 in the active region 15. In addition, the guard ring structure 26b shown in FIG. 1 is not provided at an outer edge of the trench 16; instead, the gate material 26 extends to and contacts the p-doped GaN material 20 on the inner edge of the trench 16 and at the remote location within the active region 15. In alternative embodiments, the gate material 26 may be included to form the guard ring co-integrated with the seal ring structure. The remaining features of the structure 10a are similar to the structure 10 of FIG. 1.

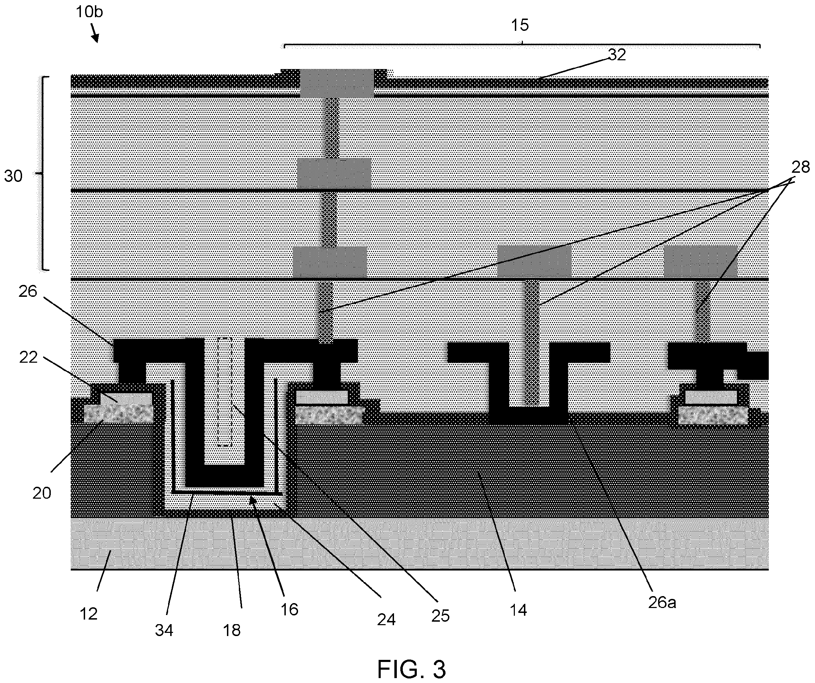

In the structure 10b of FIG. 3, a thin metal layer 34 may be provided within the trench 16, between the moisture barrier layer 18 and the gate material 26. In embodiments, the thin metal layer 34 may be provided at a bottom and sides of the trench 16. The thin metal layer 34 may be tungsten, for example, The interlevel dielectric material 24 may be provided between the moisture barrier layer 18, the gate material 26 and thin metal layer 34 may be, for example, TiN or TaN. The remaining features of the structure 10b are similar to the structure 10 of FIG. 1.

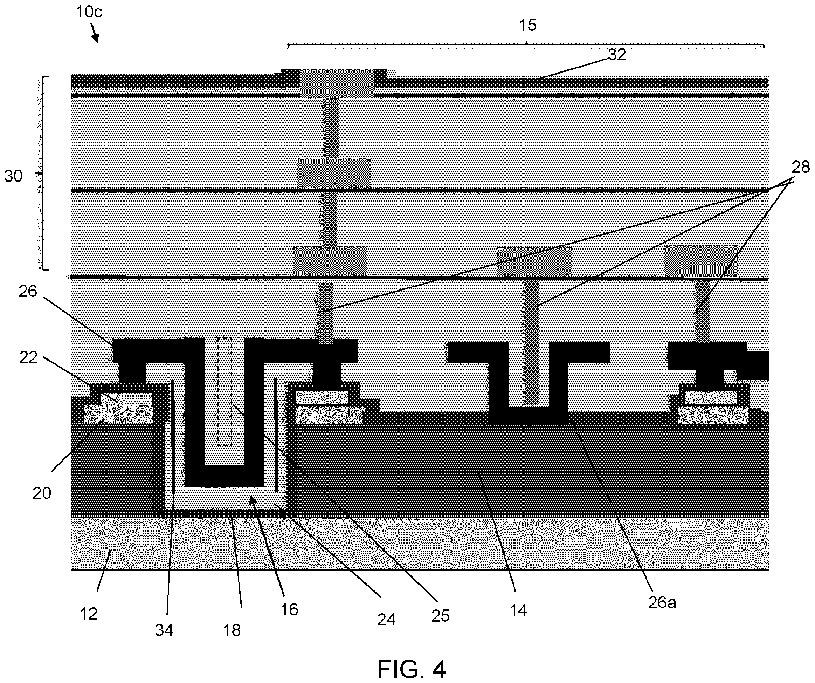

In the structure 10c of FIG. 4, the thin metal layer 34 may be provided adjacent to the sidewalls of the trench 16, between the moisture barrier layer 18 and the gate metal 26. The remaining features of the structure 10c are similar to the structure 10b of FIG. 3.

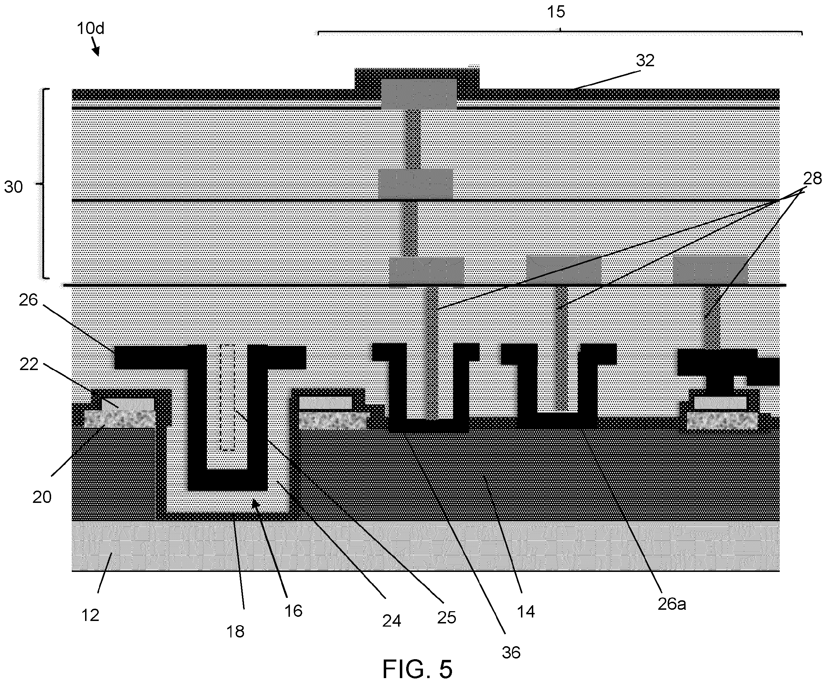

In the structure 10d of FIG. 5, a metal material 36 connecting to the source/drain region may be provided in the active region 15. The metal material 36 may be the same material as the materials 26, 26a, as an example. The metal material 36 can be used as a guard ring structure, in combination with the moisture barrier layer 18 being used as the seal ring structure. Also, the gate material does not extend to the p-doped GaN material 20 on either side of the trench 16; although such a layout is still contemplated herein. The remaining features of the structure 10d are similar to the structure 10 of FIG. 1.

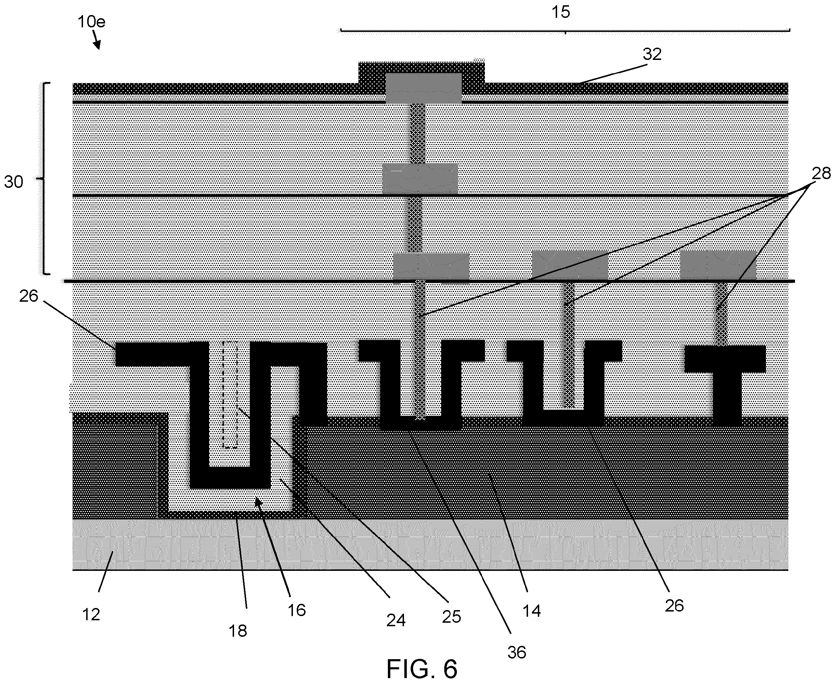

FIG. 6 shows a MISHEMT device 10e, which is devoid of patterned p-doped GaN material 20 and conductive material 22 on sides of the trench 16 and within the active region 15. In this structure, the metal material 36 and gate material 26 in the active region 15 connect to the underlying GaN stack 14. The remaining features of the structure 10e are similar to the structure 10d of FIG. 5.

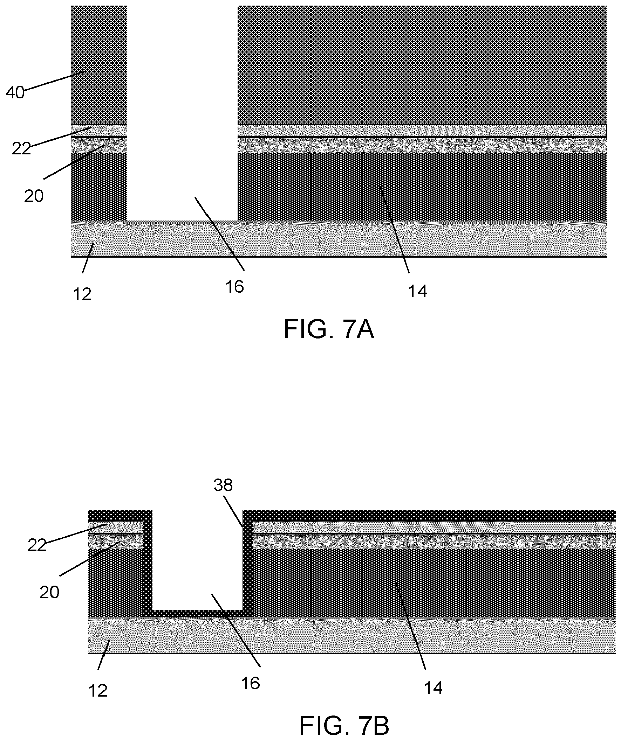

FIGS. 7A-7G show fabrication processes for manufacturing the structure of FIG. 1. In FIG. 7A, a GaN stack 14 may be deposited on the semiconductor substrate 12, and a p-doped GaN material 20 and conductive material 22, e.g., TiN, may be deposited on the GaN stack 14. In embodiments, the deposition process for these materials can be any known deposition processes such as, for example, chemical vapor deposition (CVD). A hardmask 40 may be deposited on the conductive material 22. The hardmask 40 may be representative of a photoresist stack of materials.

The trench 16 may be formed in the materials 20, 22, 14 using conventional lithography and etching processes. For example, the hardmask 40 (e.g., resist) formed over the conductive material 22 is exposed to energy (light) to form a pattern (opening). An etching process with a selective chemistry, e.g., reactive ion etching (RIE), will be used to transfer the pattern to form the trench 16 in the materials 20, 22, 14, through the opening of the hardmask 40.

In FIG. 7B, the hardmask may be removed by a conventional oxygen ashing process or other known stripants. For example, the hardmask may be removed by a known HF process. A liner 38 may be formed in the trench 16 and over the conductive material 22. The liner 38 may be a nitride material deposited by a conventional CVD process.

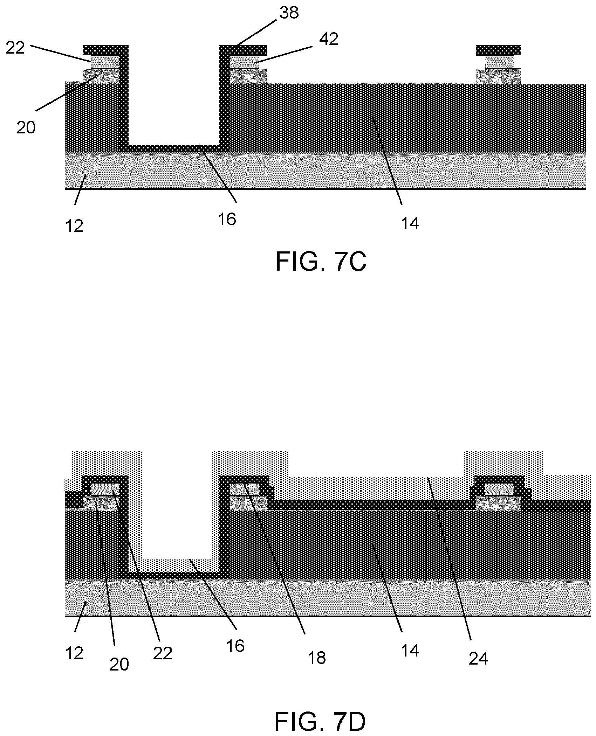

In FIG. 7C, the liner 38, conductive material 22 and the p-doped GaN material 20 can be patterned using conventional lithography and etching (RIE) processes. The liner 38 in the trench 16 will be protected by a thick antireflective coating (ARC), for example, during the etching process. Accordingly, the integrity of the liner 38 in the trench 16 will be preserved. The conductive material 22 can be further etched back to form an undercut 42. This undercut 42, e.g., pullback, will ensure gate reliability. In this way, gate stacks can be formed over the GaN stack 14.

As shown in FIG. 7D, the remaining portions of the liner 38 may be removed by a conventional stripping process, e.g., nitride strip. The moisture barrier layer 18 may be deposited over the gate stacks, e.g., patterned conductive material 22 and p-doped GaN material 20, and within the trench 16. In embodiments, the moisture barrier layer 18 may be, for example, a nitride material or Al₂O₃ and nitride material, as examples. The moisture barrier layer 18 may be deposited by a conventional deposition process, e.g., atomic layer deposition (ALD) processes. Following the deposition of the moisture barrier layer 18, an interlevel dielectric material 24 may be deposited over the moisture barrier layer 18. The interlevel dielectric material 24 may be SiO₂, for example, deposited by a conventional CVD process.

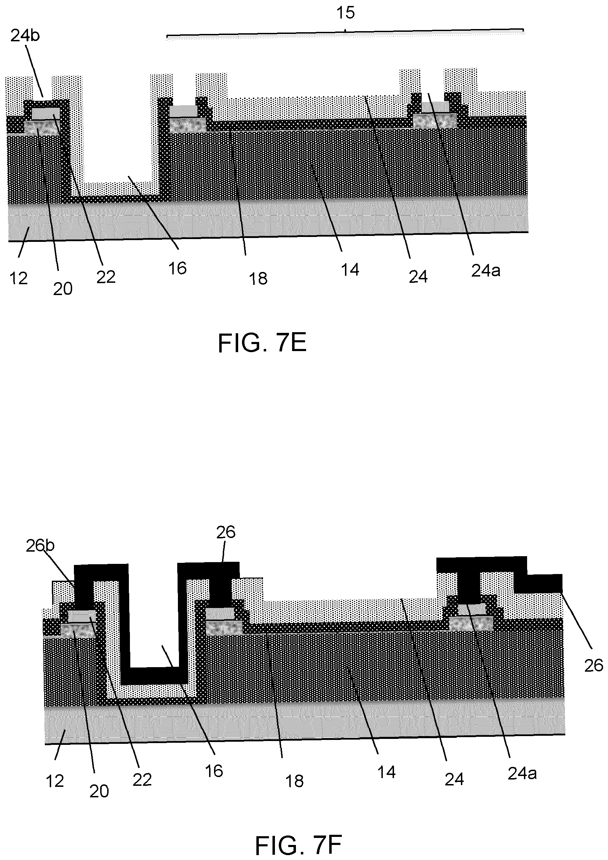

In FIG. 7E, trenches 24a may be formed in the interlevel dielectric material 24 and moisture barrier layer 18, exposing the patterned conductive material 22 of the gate stacks within the active region 15. A trench 24b on the outer edge of the trench 16 may also be formed, but this trench 24b may not punch through the moisture barrier layer 18. The trenches 24a, 24b may be formed by a conventional stem etch with a thick bottom antireflective coating (BARC) used in the lithography process.

As further shown in FIG. 7F, the gate material 26 may be blanket deposited on the interlevel dielectric material 24. In this step, the gate material 26 may be deposited in the trenches 24a contacting the underlying, exposed conductive material 22. In addition, the gate material 26 may be deposited in the trenches 24b contacting the underlying, exposed moisture barrier layer 18 to form a guard ring structure 26b. The gate material 26 may be deposited in the trench 16, providing additional moisture prevention. The gate material 26 may be deposited using a conventional sputtering technique known to those of skill in the art. The gate material 26 may be Al or Al with TiN or TaN, as examples. The gate material 26 may be patterned using conventional patterning processes, e.g., lithography and RIE, to form the gate material 26, 26a and guard ring 26b.

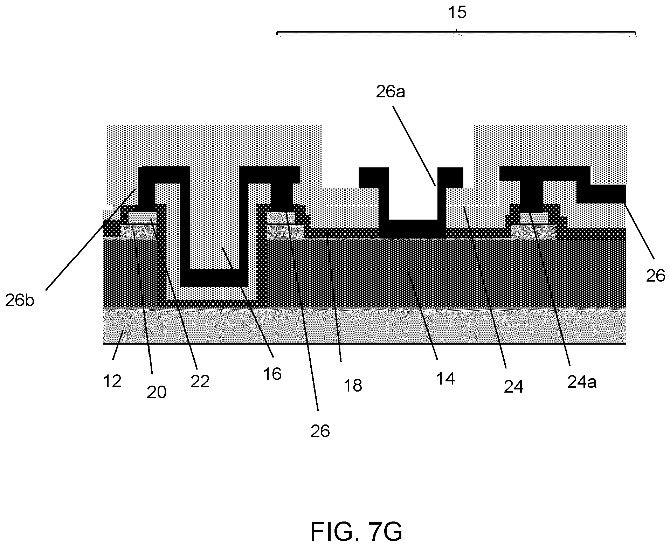

As shown in FIG. 7G, additional interlevel dielectric material 24 may be deposited within the trench 16 and above the gate material 26. The additional interlevel dielectric material 24 may be deposited by a conventional CVD process. The additional interlevel dielectric material 24 and the underlying moisture barrier layer 18 may be subjected to lithography and etching (RIE) processes as already described herein to expose a portion of the GaN stack 14 in the active region 15. A metal material 26a may be formed in contact with the GaN stack 14 in the active region 15. That is, the metal material 26a may be formed directly on, e.g., contacting, the GaN stack 14, extending through an opening in the moisture barrier layer 18. In this way, a source/drain contact may be formed.

Referring back to FIG. 1, the contacts 28, back end of the line (BEOL) structures 30, and upper passivation layer 32 may be provided using conventional CMOS processes. For example, the BEOL structures 30 may include interconnects and wiring structures at different wiring levels, formed using conventional lithography, etching and deposition processes. Following deposition processes for each wiring layer, the materials can be subjected to a planarization process (e.g., chemical mechanical process) to prepare the surface of deposition of additional materials in the next wiring level as should be understood by those of skill in the art.

The seal ring structures can be utilized in system on chip (SoC) technology. The SoC is an integrated circuit (also known as a "chip") that integrates all components of an electronic system on a single chip or substrate. As the components are integrated on a single substrate, SoCs consume much less power and take up much less area than multichip designs with equivalent functionality. Because of this, SoCs are becoming the dominant force in the mobile computing (such as in Smartphones) and edge computing markets. SoC is also used in embedded systems and the Internet of Things.

The method(s) as described above is used in the fabrication of integrated circuit chips. The resulting integrated circuit chips can be distributed by the fabricator in raw wafer form (that is, as a single wafer that has multiple unpackaged chips), as a bare die, or in a packaged form. In the latter case the chip is mounted in a single chip package (such as a plastic carrier, with leads that are affixed to a motherboard or other higher level carrier) or in a multichip package (such as a ceramic carrier that has either or both surface interconnections or buried interconnections). In any case the chip is then integrated with other chips, discrete circuit elements, and/or other signal processing devices as part of either (a) an intermediate product, such as a motherboard, or (b) an end product. The end product can be any product that includes integrated circuit chips, ranging from toys and other low-end applications to advanced computer products having a display, a keyboard or other input device, and a central processor.

The descriptions of the various embodiments of the present disclosure have been presented for purposes of illustration, but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure (10) comprising:
a semiconductor substrate (12);
a channel layer above the semiconductor substrate (12);
a trench (16) within the channel layer, extending to the semiconductor substrate (12); and
a moisture barrier layer (18) lining sidewalls and a bottom surface of the trench (16).

2. The structure (10) of claim 1, wherein the channel layer comprises a stack (14) of material comprising at least GaN.

3. The structure (10) of claim 1 or 2, wherein the trench (16) is at an edge of an active region (15).

4. The structure (10) of one of claims 1 to 3, further comprising a gate material (26) in the trench (16) and separated from the moisture barrier layer (18) by a dielectric material (24) and further optionally comprising an airgap (25) in the dielectric material (24) above the gate material (26) and further optionally comprising a guard ring (26b) at an outer edge of the trench (16), extending from the gate material (26).

5. The structure (10) of claim 4, wherein the gate material (26) contacts the channel layer and extends through the moisture barrier layer (18) within an active region (15) outside of the trench (16).

6. The structure (10) of claim 4 or 5, further comprising a metal layer (34) within the trench (16) and between the gate material (26) and the moisture barrier layer (18), adjacent to sidewalls of the trench (16), wherein the metal layer (34) is optionally adjacent to a bottom surface of the trench (16).

7. The structure (10) of one of claims 1 to 6, further comprising a metal material (26a) extending through the moisture barrier layer (18) within an active region (15) and contacting the channel layer.

8. The structure (10) of one of claims 4 to 7, further comprising a gate stack at an inner edge of the trench (16) within an active region (15), the moisture barrier layer (18) over the gate stack, and the gate material (26) contacting the gate stack within the active region (15).

9. The structure (10) of one of claims 1 to 8, further comprising a gate stack at an outer edge of the trench (16), the moisture barrier layer (18) over the gate stack at the outer edge, and the gate material (26) contacting the moisture barrier layer (18) over the gate stack at the outer edge.

10. A structure (10) comprising:
a first semiconductor substrate;
a second semiconductor substrate having a bandgap different than the semiconductor substrate:
a trench (16) in the second semiconductor substrate at an edge of an active region (15) and which extends to the first semiconductor substrate;
a moisture barrier layer (18) lining sidewalls and a bottom surface of the trench (16); and
gate material (26) within the trench (16) and extending outside of the trench (16), at least above the moisture barrier layer (18).

11. The structure (10) of claim 10, wherein the second semiconductor substrate comprises a stack (14) of material comprising at least GaN.

12. The structure (10) of claim 10 or 11, further comprising an airgap (25) in a dielectric material (24) above the gate material (26) and/or optionally further comprising a metal layer (34) within the trench (16) and between the gate material (26) and the moisture barrier layer (18).

13. The structure (10) of one of claims 10 to 12, wherein the gate material (26) contacts the moisture barrier layer (18) at an edge of the trench (16) outside of the active region (15).

14. The structure (10) of one of claims 10 to 13, further comprising a metal material (26a) extending through the moisture barrier layer (18) within the active region (15) and contacting the second semiconductor substrate and/or optionally further comprising a gate stack at an inner edge of the trench (16) within the active region (15), the moisture barrier layer (18) over the gate stack, and the gate material (26) contacting the gate stack within the active region (15).

15. A method comprising:
forming a channel layer above a semiconductor substrate (12);
forming a trench (16) within the channel layer, extending to the semiconductor substrate (12); and
forming a moisture barrier layer (18) lining sidewalls and a bottom surface of the trench (16).
